# EUROPÄISCHE PATENTANMELDUNG

(11) **EP 1 772 533 A1**
(43) Veröffentlichungstag der Anmeldung: **11.04.2007**
(21) Anmeldenummer: 05021895.7
(22) Anmeldetag: 07.10.2005
(51) Int. Cl.: C23C 16/04, F01D 5/28

(54) **Vorrichtung zur Innenbeschichtung, Retorte und Verfahren zur Innenbeschichtung**

(71) Anmelder: SIEMENS AKTIENGESELLSCHAFT, 80333 München (DE)
(72) Erfinder: Beck, Thomas, 16341 Panketal (DE); Berndt, Thomas, 12524 Berlin (DE); Ladru, Francis-Jurjen, Dr., 14050 Berlin (DE); Müller, Jean, 10589 Berlin (DE); Riemann, Michael, 12309 Berlin (DE)

(57) **Zusammenfassung**

Bei Innenbeschichtungsverfahren besteht häufig das Problem darin, dass eine äußere Oberfläche des zu beschichtenden hohlen Bauteils mitbeschichtet wird.

Die erfindungsgemäße Vorrichtung (1) besteht darin, dass die äußere Oberfläche (13) des Bauteils (2) durch ein Rohrelement (4), das im Bereich (32) der Austrittsöffnung (7) des hohlen Bauteils (2) anliegt, geschützt ist, wenn der Hohlraum (10) des Bauteils (2) beschichtet wird.

## Beschreibung

Die Erfindung betrifft eine Vorrichtung zur Innenbeschichtung eines Hohlkörpers gemäß Anspruch 1, eine Retorte gemäß Anspruch 8 und ein Verfahren zur Innenbeschichtung gemäß Anspruch 9.

Hohlkörper, wie z.B. gegossene Turbinenschaufeln weisen Hohlräume auf, die zwecks Oxidation und/oder Korrosionsschutzes mit einer Innenbeschichtung, insbesondere einer metallischen Beschichtung beschichtet werden. Als Beschichtungsverfahren stehen hier Gasbeschichtungsverfahren zur Verfügung, wie z.B. das CVD- oder PVD-Verfahren. Dabei wird das Metall mittels eines Trägergases in den Hohlraum geleitet und kondensiert dort auf den Innenflächen des Hohlkörpers. Dabei bildet sich dann beispielsweise eine metallische Korrosionsschutzschicht zwischen 30 und 100µm. Ein Trägergas wird in der Regel durch Öffnungen im Schaufelfuß der Turbinenschaufel eingeleitet, durchströmt den Hohlraum und tritt durch schaufelspezifische Öffnungen, z.B. an einer Austrittskante wieder aus. Die ganze Turbinenschaufel befindet sich dabei in einer Retorte in der gezielt Druck und Temperatur prozessspezifisch eingestellt werden können. Nach dem Ausströmen des Trägergases mit dem Metall aus der Austrittskante der Turbinenschaufel kondensiert das Metall in ungewünschter Weise auch auf der äußeren Oberfläche der Turbinenschaufel. Diese Beschichtungsreste müssen nach der Entnahme der Turbinenschaufel aus der Retorte aufwendig mittels Strahlen oder sonstigem abrasiven Verfahren entfernt werden. Dies dauert sehr lange und ist sehr personalintensiv.

Die EP 1 403 395 B1 offenbart eine Gasphasenaluminisierung, bei der ein Maskierungsgehäuse verwendet wird.

Es ist daher Aufgabe der Erfindung eine Vorrichtung zur Innenbeschichtung und eine Retorte aufzuweisen, mit der eine Beschichtung der äußeren Oberfläche eines Bauteils während des Innenbeschichtungsverfahrens verhindert werden kann und ein Verfahren zur Innenbeschichtung aufzuzeigen, durch das eine äußere Beschichtung verhindert wird.

Die Aufgabe wird gelöst durch eine Vorrichtung gemäß Anspruch 1, eine Retorte gemäß Anspruch 8 und durch ein Verfahren gemäß Anspruch 9.

Weitere vorteilhafte Maßnahmen sind in den Unteransprüchen aufgelistet, die beliebig in vorteilhafter Art und Weise miteinander kombiniert werden können.

Es zeigen
- Figur 1: schematisch eine erfindungsgemäße Vorrichtung im Querschnitt,
- Figur 2: eine Seitenansicht der erfindungsgemäßen Vorrichtung,
- Figur 3: eine perspektivische Ansicht einer Turbinenschaufel,
- Figur 4: eine perspektivische Ansicht einer Gasturbine.

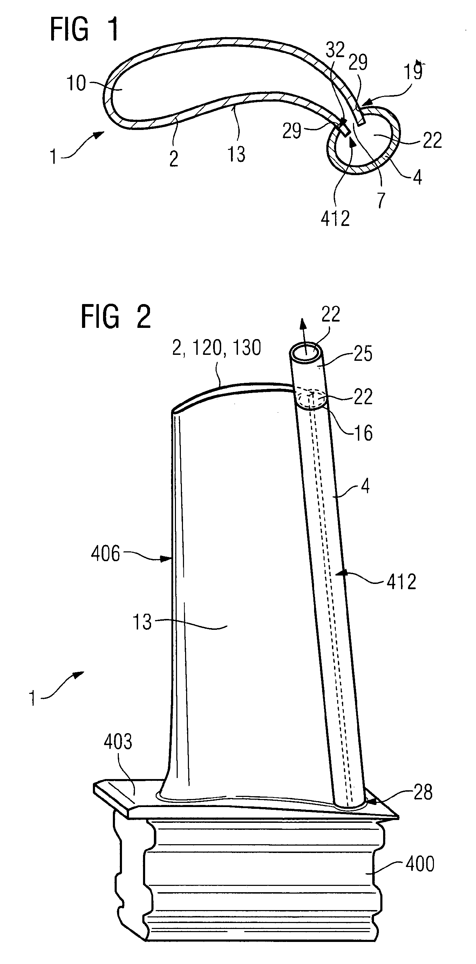

Figur 1 zeigt eine erfindungsgemäße Vorrichtung 1, die ein Bauteil 2 mit einem Hohlraum 10 aufweist.

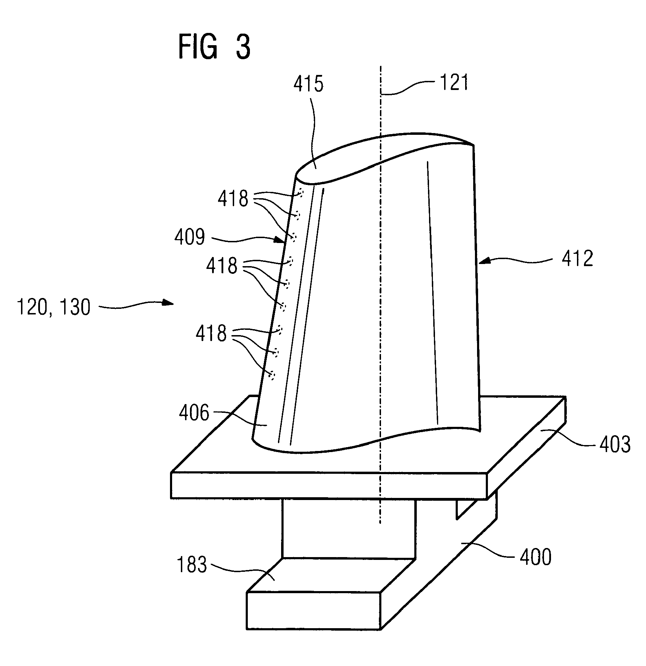

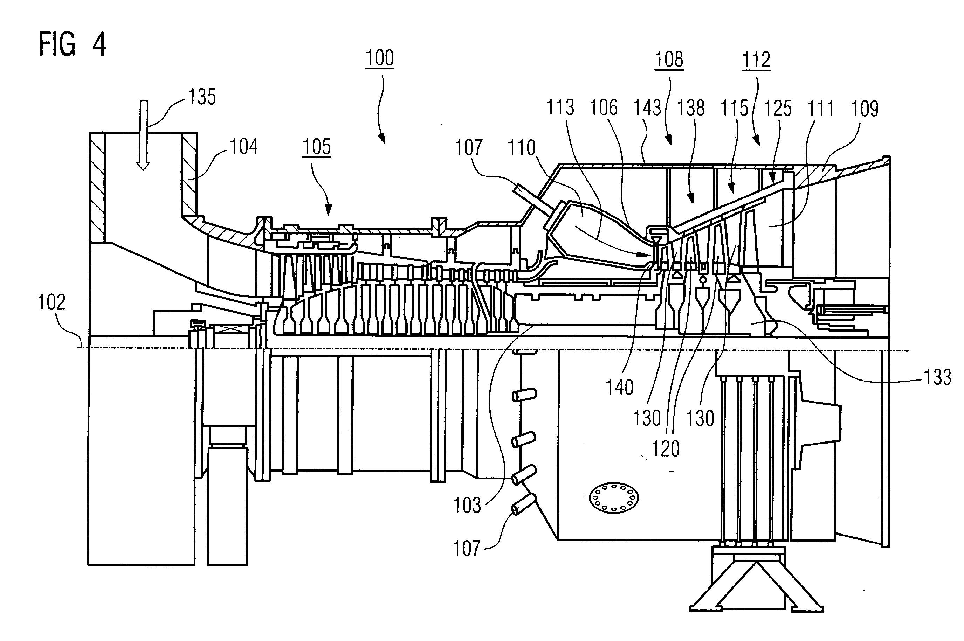

Im vorliegenden Fall handelt es sich um eine Turbinenschaufel 120, 130 (Figur 3, 4), die hier exemplarisch für alle hohlen Bauteile 2 beschrieben wird.

Die Turbinenschaufel 120, 130, insbesondere eine Gasturbinenschaufel weist zumindest eine Austrittsöffnung 7 im Bereich ihrer Abströmkante 412 auf, wobei die Austrittsöffnungen 7 vorzugsweise entlang einer Hinterkante 412 angeordnet sind und zusammen eine längliche Form aufweisen. Ebenso kann eine längliche Austrittsöffnung 7 vorhanden sein.

In den Hohlraum 10 wird ein Beschichtungsmaterial eingeführt, wobei dieses durch die Austrittsöffnungen 7 aus dem Hohlraum 10 wieder herausströmt. Im Falle einer Turbinenschaufel 120, 130 wird das Beschichtungsmaterial durch eine Öffnung im Schaufelfuß 400 eingeführt.

Insbesondere handelt es sich bei dem Beschichtungsverfahren um ein Alitierung- und/oder Chromierungsverfahren. Als Beschichtungsverfahren stehen hier Gasbeschichtungsverfahren zur Verfügung, wie z.B. das CVD- oder PVD-Verfahren sowie das Packverfahren. Dabei wird das Metall mittels eines Trägergases durch Öffnungen im Schaufelfuß 400 der Turbinenschaufel 120, 130 in den Hohlraum 10 geleitet, durchströmt den Hohlraum 10 und kondensiert dort auf den Innenflächen des Hohlkörpers 120, 130 und tritt durch schaufelspezifische Öffnungen, vorzugsweise an der Austrittsöffnung 7 im Bereich der Hinterkante 412 wieder aus. Dabei bildet sich dann beispielsweise eine metallische Korrosionsschutzschicht zwischen 30µm und 100µm aus.
Die ganze Turbinenschaufel 120, 130 befindet sich dabei vorzugsweise in einer Retorte, in der gezielt Druck P und Temperatur T prozessspezifisch eingestellt werden können (nicht dargestellt). Die Innenbeschichtung kann aber auch ohne Retorte durchgeführt werden.

Ebenso kann ein Schlicker oder eine Paste in den Hohlraum 10 eingebracht werden, wobei dieser Schlicker erhitzt wird, so dass ein Dampf, insbesondere metallischer Dampf entsteht, der sich auf den Innenflächen des Hohlraums 10 niederschlägt.

Bezüglich der Auswahl des Beschichtungsverfahrens des Hohlraums 10 besteht hier keinerlei Einschränkung. Auch das Packverfahren kann verwendet werden, wobei das Material des Packverfahrens in den Hohlraum 10 eingeführt und dort erhitzt wird.

Im Bereich der Austrittsöffnung 7 ist erfindungsgemäß ein Rohrelement 4 vorhanden, das an dem Bauteil 2, insbesondere in einem Bereich 32 auf dem Schaufelblatt 406 nahe der Austrittsöffnungen 7 anliegt und dabei die Austrittsöffnungen 7 insbesondere vollständig umschließt. Die Austrittsöffnungen 7 sind dann von außen her vollständig durch das Rohrelement 4 abgedeckt und nicht mehr zu erkennen (Fig. 2).

Das Rohrelement 4 ist vorzugsweise ein Rohr, das einen Schlitz 19 aufweist, der etwas breiter als die Hinterkante 412 der Turbinenschaufel 120, 130 ausgebildet ist und hat beispielsweise einen kreis- oder ovalförmigen Querschnitt im Längsschnitt.

Das Rohrelement 4 wird an die Turbinenschaufel 120, 130 im Bereich 32 der Austrittsöffnungen 7 angelegt und gegebenenfalls an Berührungsflächen 29 von Rohrelement 4 und Schaufelblatt 406 gegenüber der Turbinenschaufel 120, 130 abgedichtet. Ebenso kann das Rohrelement 4 im Bereich 28 der Berührungsflächen der Plattform 403 abgedichtet (Fig. 2) werden.

Das Gas, das den Hohlraum 10 zwangsläufig verlassen muss, strömt dann in das Rohrelement 4 ein und gelangt deshalb nicht auf die äußeren Oberflächen 13 der Turbinenschaufel 2. Das Rohrelement 4 kann an einem Ende 16 mit einer Verlängerung 25 so ausgebildet sein, dass es keinen Schlitz 19 mehr aufweist, sondern ein geschlossenes Rohr darstellt, das ggf. aus der Retorte hinausgeführt wird.

Ebenso ist es denkbar, dass im Bereich einer Öffnung 22 des Rohrelements 4 aus der das Gas aus dem Hohlraum 10 in das Rohrelement 4 austritt, eine Absaugvorrichtung vorhanden ist, die den ausströmenden Dampf absaugt und so verhindert, dass sich der Dampf des Beschichtungsmaterials auf den Außenflächen 13 der Turbinenschaufel 2 abscheidet. In diesem Fall kann auf eine Retorte verzichtet werden.

Figur 3 zeigt in perspektivischer Ansicht eine Laufschaufel 120 oder Leitschaufel 130 einer Strömungsmaschine, die sich entlang einer Längsachse 121 erstreckt.

Die Strömungsmaschine kann eine Gasturbine eines Flugzeugs oder eines Kraftwerks zur Elektrizitätserzeugung, eine Dampfturbine oder ein Kompressor sein.

Die Schaufel 120, 130 weist entlang der Längsachse 121 aufeinander folgend einen Befestigungsbereich 400, eine daran angrenzende Schaufelplattform 403 sowie ein Schaufelblatt 406 auf.
Als Leitschaufel 130 kann die Schaufel 130 an ihrer Schaufelspitze 415 eine weitere Plattform aufweisen (nicht dargestellt) .

Im Befestigungsbereich 400 ist ein Schaufelfuß 183 gebildet, der zur Befestigung der Laufschaufeln 120, 130 an einer Welle oder einer Scheibe dient (nicht dargestellt).
Der Schaufelfuß 183 ist beispielsweise als Hammerkopf ausgestaltet. Andere Ausgestaltungen als Tannenbaum- oder Schwalbenschwanzfuß sind möglich.
Die Schaufel 120, 130 weist für ein Medium, das an dem Schaufelblatt 406 vorbeiströmt, eine Anströmkante 409 und eine Abströmkante 412 auf.

Bei herkömmlichen Schaufeln 120, 130 werden in allen Bereichen 400, 403, 406 der Schaufel 120, 130 beispielsweise massive metallische Werkstoffe, insbesondere Superlegierungen verwendet.
Solche Superlegierungen sind beispielsweise aus der EP 1 204 776 B1, EP 1 306 454, EP 1 319 729 A1, WO 99/67435 oder WO 00/44949 bekannt; diese Schriften sind bzgl. der chemischen Zusammensetzung der Legierung Teil der Offenbarung.
Die Schaufel 120, 130 kann hierbei durch ein Gussverfahren, auch mittels gerichteter Erstarrung, durch ein Schmiedeverfahren, durch ein Fräsverfahren oder Kombinationen daraus gefertigt sein.
Werkstücke mit einkristalliner Struktur oder Strukturen werden als Bauteile für Maschinen eingesetzt, die im Betrieb hohen mechanischen, thermischen und/oder chemischen Belastungen ausgesetzt sind.
Die Fertigung von derartigen einkristallinen Werkstücken erfolgt z.B. durch gerichtetes Erstarren aus der Schmelze. Es handelt sich dabei um Gießverfahren, bei denen die flüssige metallische Legierung zur einkristallinen Struktur, d.h. zum einkristallinen Werkstück, oder gerichtet erstarrt.
Dabei werden dendritische Kristalle entlang dem Wärmefluss ausgerichtet und bilden entweder eine stängelkristalline Kornstruktur (kolumnar, d.h. Körner, die über die ganze Länge des Werkstückes verlaufen und hier, dem allgemeinen Sprachgebrauch nach, als gerichtet erstarrt bezeichnet werden) oder eine einkristalline Struktur, d.h. das ganze Werkstück besteht aus einem einzigen Kristall. In diesen Verfahren muss man den Übergang zur globulitischen (polykristallinen) Erstarrung meiden, da sich durch ungerichtetes Wachstum notwendigerweise transversale und longitudinale Korngrenzen ausbilden, welche die guten Eigenschaften des gerichtet erstarrten oder einkristallinen Bauteiles zunichte machen.
Ist allgemein von gerichtet erstarrten Gefügen die Rede, so sind damit sowohl Einkristalle gemeint, die keine Korngrenzen oder höchstens Kleinwinkelkorngrenzen aufweisen, als auch Stängelkristallstrukturen, die wohl in longitudinaler Richtung verlaufende Korngrenzen, aber keine transversalen Korngrenzen aufweisen. Bei diesen zweitgenannten kristallinen Strukturen spricht man auch von gerichtet erstarrten Gefügen (directionally solidified structures).
Solche Verfahren sind aus der US-PS 6,024,792 und der EP 0 892 090 A1 bekannt; diese Schriften sind Teil der Offenbarung.

Ebenso können die Schaufeln 120, 130 Beschichtungen gegen Korrosion oder Oxidation aufweisen, z. B. (MCrAlX; M ist zumindest ein Element der Gruppe Eisen (Fe), Kobalt (Co), Nickel (Ni), X ist ein Aktivelement und steht für Yttrium (Y) und/oder Silizium und/oder zumindest ein Element der Seltenen Erden, bzw. Hafnium (Hf)). Solche Legierungen sind bekannt aus der EP 0 486 489 B1, EP 0 786 017 B1, EP 0 412,397 B1 oder EP 1 306 454 A1, die bzgl. der chemischen Zusammensetzung der Legierung Teil dieser Offenbarung sein sollen.

Eine Innenbeschichtung erfolgt durch das erfindungsgemäße Verfahren mit der erfindungsgemäßen Vorrichtung 1.

Auf der MCrAlX kann noch eine Wärmedämmschicht vorhanden sein und besteht beispielsweise aus ZrO₂, Y₂O₃-ZrO₂, d.h. sie ist nicht, teilweise oder vollständig stabilisiert durch Yttriumoxid und/oder Kalziumoxid und/oder Magnesiumoxid.
Durch geeignete Beschichtungsverfahren wie z.B. Elektronenstrahlverdampfen (EB-PVD) werden stängelförmige Körner in der Wärmedämmschicht erzeugt.

Wiederaufarbeitung (Refurbishment) bedeutet, dass Bauteile 120, 130 nach ihrem Einsatz gegebenenfalls von Schutzschichten befreit werden müssen (z.B. durch Sandstrahlen). Danach erfolgt eine Entfernung der Korrosions- und/oder Oxidationsschichten bzw. -produkte. Gegebenenfalls werden auch noch Risse im Bauteil 120, 130 repariert. Danach erfolgt eine Wiederbeschichtung des Bauteils 120, 130 und ein erneuter Einsatz des Bauteils 120, 130.

Die Schaufel 120, 130 kann hohl oder massiv ausgeführt sein. Wenn die Schaufel 120, 130 gekühlt werden soll, ist sie hohl und weist ggf. noch Filmkühllöcher 418 (gestrichelt angedeutet) auf.

Die Figur 4 zeigt beispielhaft eine Gasturbine 100 in einem Längsteilschnitt.
Die Gasturbine 100 weist im Inneren einen um eine Rotationsachse 102 drehgelagerten Rotor 103 mit einer Welle 101 auf, der auch als Turbinenläufer bezeichnet wird.

Entlang des Rotors 103 folgen aufeinander ein Ansauggehäuse 104, ein Verdichter 105, eine beispielsweise torusartige Brennkammer 110, insbesondere Ringbrennkammer, mit mehreren koaxial angeordneten Brennern 107, eine Turbine 108 und das Abgasgehäuse 109.
Die Ringbrennkammer 110 kommuniziert mit einem beispielsweise ringförmigen Heißgaskanal 111. Dort bilden beispielsweise vier hintereinander geschaltete Turbinenstufen 112 die Turbine 108.
Jede Turbinenstufe 112 ist beispielsweise aus zwei Schaufelringen gebildet. In Strömungsrichtung eines Arbeitsmediums 113 gesehen folgt im Heißgaskanal 111 einer Leitschaufelreihe 115 eine aus Laufschaufeln 120 gebildete Reihe 125.

Die Leitschaufeln 130 sind dabei an einem Innengehäuse 138 eines Stators 143 befestigt, wohingegen die Laufschaufeln 120 einer Reihe 125 beispielsweise mittels einer Turbinenscheibe 133 am Rotor 103 angebracht sind.
An dem Rotor 103 angekoppelt ist ein Generator oder eine Arbeitsmaschine (nicht dargestellt).

Während des Betriebes der Gasturbine 100 wird vom Verdichter 105 durch das Ansauggehäuse 104 Luft 135 angesaugt und verdichtet. Die am turbinenseitigen Ende des Verdichters 105 bereitgestellte verdichtete Luft wird zu den Brennern 107 geführt und dort mit einem Brennmittel vermischt. Das Gemisch wird dann unter Bildung des Arbeitsmediums 113 in der Brennkammer 110 verbrannt. Von dort aus strömt das Arbeitsmedium 113 entlang des Heißgaskanals 111 vorbei an den Leitschaufeln 130 und den Laufschaufeln 120. An den Laufschaufeln 120 entspannt sich das Arbeitsmedium 113 impulsübertragend, so dass die Laufschaufeln 120 den Rotor 103 antreiben und dieser die an ihn angekoppelte Arbeitsmaschine.

Die dem heißen Arbeitsmedium 113 ausgesetzten Bauteile unterliegen während des Betriebes der Gasturbine 100 thermischen Belastungen. Die Leitschaufeln 130 und Laufschaufeln 120 der in Strömungsrichtung des Arbeitsmediums 113 gesehen ersten Turbinenstufe 112 werden neben den die Ringbrennkammer 110 auskleidenden Hitzeschildelementen am meisten thermisch belastet.
Um den dort herrschenden Temperaturen standzuhalten, können diese mittels eines Kühlmittels gekühlt werden.
Ebenso können Substrate der Bauteile eine gerichtete Struktur aufweisen, d.h. sie sind einkristallin (SX-Struktur) oder weisen nur längsgerichtete Körner auf (DS-Struktur).
Als Material für die Bauteile, insbesondere für die Turbinenschaufel 120, 130 und Bauteile der Brennkammer 110 werden beispielsweise eisen-, nickel- oder kobaltbasierte Superlegierungen verwendet.
Solche Superlegierungen sind beispielsweise aus der EP 1 204 776 B1, EP 1 306 454, EP 1 319 729 A1, WO 99/67435 oder WO 00/44949 bekannt; diese Schriften sind bzgl. der chemischen Zusammensetzung der Legierungen Teil der Offenbarung.

Die Leitschaufel 130 weist einen dem Innengehäuse 138 der Turbine 108 zugewandten Leitschaufelfuß (hier nicht dargestellt) und einen dem Leitschaufelfuß gegenüberliegenden Leitschaufelkopf auf. Der Leitschaufelkopf ist dem Rotor 103 zugewandt und an einem Befestigungsring 140 des Stators 143 festgelegt.

## Patentansprüche

1. Vorrichtung (1) zur Innenbeschichtung eines Hohlraums (10) eines Bauteils (2),
wobei das Bauteil (2) zumindest eine Austrittsöffnung (7) aufweist,
zumindest bestehend aus
einem Rohrelement (4),
das die Austrittsöffnung (7) vollständig umschließt und an dem Bauteil (2) anliegt.

2. Vorrichtung nach Anspruch 1,
bei der das Rohrelement (4) in einem Bereich (32) nahe der Austrittsöffnung (7) an dem Bauteil (2) anliegt.

3. Vorrichtung nach Anspruch 1 oder 2,
bei der das Rohrelement (4) in einem Bereich (32) des Bauteils (2) und der Berührungsflächen (28, 29) des Rohrelements (4) gegenüber dem Bauteil (2) abgedichtet ist.

4. Vorrichtung nach Anspruch 1 oder 3,
bei der die Austrittsöffnung (7) eine längliche Form aufweist.

5. Vorrichtung nach Anspruch 4,
bei der das Rohrelement (4) ein Rohr mit einem Schlitz (19) darstellt.

6. Vorrichtung nach Anspruch 1, 2, 3 oder 5,
bei der das Rohrelement (4) an einem Ende eine Verlängerung (25) aufweist,
die ein vollständiges geschlossenes Rohr darstellt.

7. Vorrichtung nach Anspruch 1, 2 oder 3,
bei der das Bauteil (2) eine Turbinenschaufel (120, 130) ist.

8. Retorte in der eine Vorrichtung (1) nach Anspruch 1, 2, 3, 4, 5, 6 oder 7 angeordnet ist,
in der Temperatur (T) und/oder Druck (p) einstellbar sind.

9. Verfahren zur Innenbeschichtung eines Bauteils (2) mit
einem Hohlraum (10),
insbesondere mittels einer Vorrichtung (1) nach einem oder mehreren der Ansprüche 1 bis 7,
bei dem an das Bauteil (2) ein Rohrelement (4) so angelegt wird,
dass ein ausströmendes Gas aus einer Austrittsöffnung (7)
des hohlen Bauteils (2) nur in das Rohrelement (4) strömen kann,
Einführen von Beschichtungsmaterial in den Hohlraum (10) des Bauteils (2),
so dass in dem Hohlraum (10) eine Innenbeschichtung stattfindet,
wobei ein Dampf des Beschichtungsmaterials aus der Austrittsöffnung (7) des hohlen Bauteils (2) in das Rohrelement (4) ausströmt,
das (4) den Dampf von den äußeren Oberflächen (13) des hohlen Bauteils (2) fernhält und ableitet,
Entfernen des Rohrelements (4) nach Ende der Innenbeschichtung.
